# EUROPEAN PATENT APPLICATION

(11) **EP 1 780 779 A2**
(43) Date of publication of application: **02.05.2007**
(21) Application number: 06121143.9
(22) Date of filing: 22.09.2006
(51) Int. Cl.: H01L 21/311, H01L 21/3213, H01L 21/3065

(54) **A plasma for patterning advanced gate stacks**

(30) Priority: 28.10.2005 US 731608 P
(71) Applicant: INTERUNIVERSITAIR MICROELEKTRONICA CENTRUM ( IMEC), 3001 Leuven (BE)
(72) Inventor: Shamiryan, Denis, 3001, Leuven (BE); Paraschiv, Vasile, 3010, Kessel-Lo (BE); Demand, Marc, 1350, Jandrain-Jandrenouille (BE); Boullart, Werner, 3211, Binkom (BE)
(74) Representative: pronovem

(57) **Abstract**

The present invention relates to plasma composition and its use in a method for the dry etching of a stack of at least one material chemically too reactive towards the use of a Cl-based plasma.

Small amounts of nitrogen (5% up to 10%) can be added to a BCl₃ comprising plasma and used in an anisotropical dry etching method whereby a passivation film is deposited onto the vertical sidewalls of stack etched for protecting the vertical sidewalls from lateral attack such that straight profiles can be obtained.

## Description

### Field of the invention

The present invention is related to the field of semiconductor processing. More specifically it is related to the dry etching of advanced gate stacks, in particular to metal gate comprising stacks and pure germanium comprising stacks.

The invention is further related to an etch plasma composition and its use for dry etching of metal gate comprising stacks and pure germanium comprising stacks thereby preserving the vertical profile of the gate stack after patterning.

### Background of the invention

As the critical dimensions in CMOS manufacturing shrink for the 90 nm technology node and beyond, conventional (poly) silicon gates are being replaced by metal gates (meaning pure metals, metal alloys or metal nitrides, etc) and SiO₂ as a gate dielectric is replaced by materials with higher dielectric constant (so called "high-k dielectrics). The key challenge is to adapt the conventional gate etch process flow to the metal gate stack. Etching this metal gate stack now requires a process that defines the metal gate profile without affecting the gate critical dimension (CD) and stops on thin gate oxide without pitting or punch through.

Etching of metal gates has been studied addressing metal gate and gate oxide surface roughness, CD control, etch selectivity, and low damage etching but none of them succeeded in preserving the vertical profile of the gate stack after patterning.

One of the promising chemistry for patterning of advanced gate stacks (metal gate etch or high-k removal) is BCl₃. The main advantage of this plasma is that it can etch both metal gates and high-k dielectric with reasonable selectivity to the Si substrate. However, there are number of gate stack materials that are incompatible with BCl₃ plasma as they are too reactive. As a result, BCl₃ produces some undesirable lateral etch that compromises the gate profiles. Two particular examples are Ge gates and TaN metal gates. If a pure BCl₃ plasma is applied during the patterning of the gate stacks containing Ge or TaN a profile distortion caused by lateral etch is observed.

### Summary

The present invention discloses a dry-etch plasma composition for preserving the vertical profile of a structure comprising a stack of layers during anisotropical dry-etch patterning.

Said plasma composition is further characterized such that during the dry-etch patterning of said stack a water-soluble film, which is removable against the structure, is deposited onto the sidewalls of said stack such that lateral attack of said patterned stack is avoided.

Preferably, the plasma composition of the present invention is characterized as a plasma comprising a boron-halogen compound and nitrogen and wherein the ratio of the boron-halogen compound to nitrogen is from 19:1 up to 9:1. More preferred, the plasma composition of the present invention is characterized as a plasma composition wherein said plasma comprises a boron-halogen compound, nitrogen and optionally an inert compound. Most preferred said boron-halogen compound is BCl₃.

Preferably, the plasma composition of the present invention is characterized as a plasma comprising (or consisting of) a boron-halogen compound and 5 up to 10% nitrogen (of the total plasma composition).

More preferably, the plasma composition comprises (or consists of) a boron-halogen compound and less than 10% nitrogen (of the total plasma composition). More particularly, said boron-halogen compound is BCl₃.

Most preferred, said plasma is (i.e. consists of) a BCl₃ plasma further comprising (or to which is added) from 5% to 10% nitrogen (based on the total plasma composition).

In a preferred embodiment, the stack of layers to be patterned is a metal gate comprising stack.

More preferred, said metal gate comprising stack comprises at least one TaN layer or combinations of a TaN layer and a TiN layer (referred to as TaN/TiN metal gates) wherein said TaN layer is too sensitive to a (pure) BCl₃ plasma. Or in other words the stack of layers to be patterned is a stack wherein at least one layer of said stack of layers is a TaN layer.

In another preferred embodiment, at least one layer of said stack of layers to be patterned is a germanium comprising layer.

Said germanium layer can be situated upon a layer to be patterned by the plasma composition of the present invention. Said germanium layer can be a pure Ge layer.

Preferably, the plasma of the present invention (during patterning) has a substrate bias which is different from zero.

Preferably, the plasma of the present invention (during patterning) has a plasma power is in the range of 100W up to 1200W. More preferred said plasma power is around 450W.
Preferably, the plasma of the present invention (during patterning) has a pressure in the plasma chamber of minimum 0.666 Pa (5mT) and maximum 10.665 Pa (80mT). More preferred said pressure is 0.666 Pa (5mT).

Preferably, the plasma of the present invention (during patterning) has a temperature below 100°C and most preferred said plasma temperature during dry-etch patterning is around 60°C.

An anisotropical dry etching method is also disclosed using the plasma composition of the present invention as described above for patterning a stack of layers to create a vertical structure wherein lateral attack during patterning of said stack is avoided.

Preferably said method comprises the steps of first applying a dry-etch step using the plasma composition of the invention wherein during the etching a protective and water-soluble film is deposited onto the vertical sidewalls of said structure such that the vertical profile of said structure is preserved and lateral attack is avoided. In a next step said water-soluble film is removed from said structure.

Said water-soluble film is preferably removed using a wet removal process using water.

The present invention also relates to the use of a plasma comprising (or consisting of) BCl₃, to which nitrogen is added to reach 5% to 10% of the total volume of the resulting plasma composition, for etching a (suitable) stack of layer (i.e. comprising at least one layer etchable by said BCl₃ component) and simultaneously passivating (or protecting) the sidewalls of said stack of layers from lateral etch.

The present invention also relates to a method for etching (or patterning) a (suitable) stack of layers while/and simultaneously passivating (or protecting) the sidewalls of said stack of layers comprising the step of providing a plasma comprising (or consisting of) BCl₃, to which nitrogen is added to reach 5% to 10% of the total volume of the resulting plasma composition.

Said use or said method is particularly useful for (patterning) a stack of layers wherein at least one layer is germanium, or at least one layer is TaN.

Said passivating (or protecting) effect results from the formation and deposition of a film (or layer) which contains boron and nitrogen (and further compounds such as oxygen) on the sidewalls of said stack of layers. Said film obtainable by a method of the invention is also an object of the present invention.

Said use or said method can be carried out in the framework of CMOS manufacture.

### Short description of the drawings

All drawings are intended to illustrate some aspects and embodiments of the present invention. Not all alternatives and options are shown and therefore the invention is not limited to the content of the given drawings.

Figure 1 shows FTIR (Fourier Transform Infrared Spectroscopy) spectra of films deposited from BCl₃/N₂ plasma mixture (70% BCl₃) at 275°C and 60°C.

Figure 2 shows a Ge gate profile after the gate patterning and before the high-k removal.

Figure 3 shows a Ge gate profile after high-k removal by pure BCl₃ plasma for 10 seconds (Figure 3A) and BCl₃/N₂ (10% N₂) plasma for 20 seconds (Figure 3B).

Figure 4 shows a TaN gate profile after etching in pure BCl₃ plasma (Figure 4A), an arrow indicates the lateral attack of TaN. Figure 4B shows a TaN gate profile after etching in BCl₃/N₂ (5% N₂) plasma.

Figure 5 shows a TaN gate profile after etching in BCl₃/N₂ plasma (Figure 5A) and a TaN gate profile after etching in BCl₃/O₂ plasma (Figure 5B).

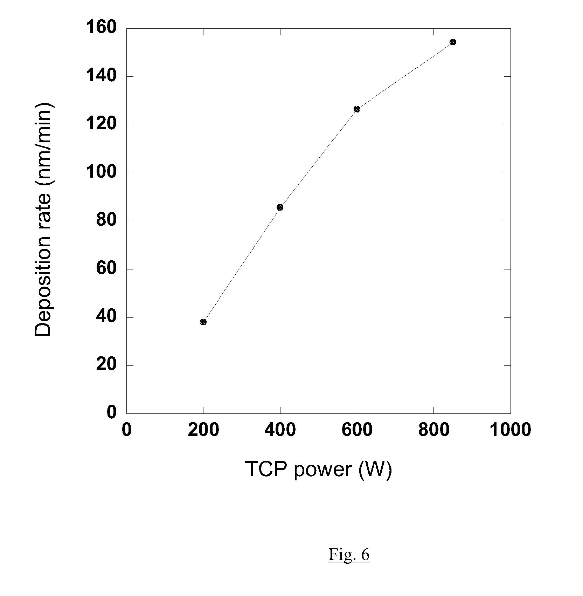

Figure 6 illustrates the deposition rate of a BxNy film using a BCl₃/N₂ plasma (Pressure = 1,333 Pa (10 mT)).

### Description of the invention

In the context of the present invention, the term "critical dimension" (CD) refers to the smallest dimensions of geometrical features (e.g. width of gate electrode) which can be formed during semiconductor device manufacturing.

In the context of the present invention the term "bias" refers to the voltage applied to the substrate during patterning in a dry etch chamber.

The term "selectivity" refers to the etch rate of a selected material towards another material. The material to be etched away should have a much higher etch rate than the other materials.

The term "ratio" is expressed as amount of a first compound to a second compound, e.g. a ratio of 9:1 means e.g. 9 sccm (standard centimeter cube per minute) of the first compound and 1 sccm of the second compound.

The invention is based on the surprising effect of using a plasma composition according to the invention, i.e. the deposition of a BxNy film during the etching of a structure wherein the deposition is performed in a plasma etch chamber (e.g. Versys 2300 etch chamber from LAM®) at low temperatures (e.g. 60°C), which was never reported before (BN deposition is usually performed at temperatures in the range 390°C-650°C). The BxNy film is deposited at a rate as high as e.g. 300 nm/min depending on the pressure, plasma power, gas flows and plasma composition (more specifically the BCl₃ to N₂ ratio). Said deposited BxNy-like film, in contrast to a pure BN film, was found to be easily decomposing by temperature (the film thickness decreases at temperatures above 100°C) and soluble in water at room temperatures.

The present invention is further related to the patterning of a stack of layers, more specifically to the dry etching of a stack of layers.

Said patterning is making use of a plasma etch compound wherein at least one of the layers is too sensitive to said etch compound. By adding an extra component to the plasma it is possible to deposit a protective layer onto the stack of layers such that said stack is protected for e.g. sidewall damage. Said protective layer is deposited during the patterning (dry etching). Furthermore said protective layer is sacrificial and hence easy removable.

The "sacrificial" layer, also referred to as "protective" layer or "passivation" layer refers to the BxNy like film resulting from the addition of nitrogen in the boron-halogen plasma, also referred to as BxNy film or as to boron nitride like film, which is deposited during etching. Said BxNy film is used as a "protective" or "passivating" film during patterning/etching of a structure, said BxNy film is also referred to as a sacrificial layer because said layer is removed after patterning is completed. Due the unstable character of the BxNy film and water soluble character said BxNy film can be easily removed by e.g. a water rinse.

The term "BxNy" film refers to a film comprising mainly boron and nitrogen which is further characterized as a water-soluble film. The BxNy film of the invention is water soluble, in contrast to a pure BN which is insoluble in water. The BxNy film is therefore referred to as BxNy wherein the integers x and y indicate that the ratio of nitrogen and boron in the film is not fixed due to the presence of other compounds (impurities) in the film such as water, oxygen and/or ammonia which are possibly absorbed from the plasma and/or atmosphere after dry-etching.

More specifically, the present invention relates to the patterning of metal gate stacks or germanium gate stacks, more specifically it relates to the dry etching of said gate stacks such as TaN comprising metal gate stacks and to the dry etching of Ge comprising stacks (or in other words a stack comprising e.g. a pure Ge layer).

The present invention solves the problem of lateral etch and profile attack during the patterning of advanced gate stacks such as metal gate stacks and germanium stacks by adding small amounts of nitrogen to a boron-halogen plasma such as BCl₃ plasma in order to improve gate profile control. The mixture of BCl₃/N₂ plasma results in a deposition of BxNy-like film that inhibits the lateral etch but does not inhibit vertical etch as the formed BxNy-like film is destroyed by ion bombardment.

A plasma composition is disclosed for patterning metal gate stacks and/or germanium stacks wherein during the patterning of said stack a protective and water-soluble film is deposited such that the vertical profile of the stack is preserved and lateral attack of said stack is avoided.

More specifically a plasma composition is disclosed for patterning a stack of layers wherein at least one layer of said stack is sensitive to one of the etch compounds.

The plasma composition is preferably a Boron-halogen comprising plasma with small additions of nitrogen.

The Boron-halogen compound is preferably BCl₃ and said small additions of nitrogen are such that the ratio of the boron-halogen compound to nitrogen is in the range of 19:1 up to 9:1.

Optionally an inert compound can be added to the plasma comprising boron-halogen and nitrogen. Said inert compound can be e.g. argon or helium (He) and these compounds can be added to the plasma in concentrations up to 50% of the total plasma composition.

For the patterning of metal gates comprising TaN, such as TaN metal gates and metal gates comprising layers of TaN and TiN (TaN/TiN metal gates) the ratio of the boron-halogen compound to nitrogen is below 9:1 (having more boron-halogen), more preferred said ratio of the boron-halogen compound to nitrogen is below 11:1 and most preferred said ratio of the boron-halogen compound to nitrogen is 19:1.

For the patterning of metal gates comprising TaN, such as TaN metal gates and metal gates comprising combinations of TaN and TiN layers (TaN/TiN metal gates) the ratio of BCl₃ to nitrogen is below 9:1, more preferred said ratio of BCl₃ to nitrogen is below 11:1 and most preferred said ratio of BCl₃ to nitrogen is 19:1.

For the patterning of germanium comprising stacks wherein germanium is at least one of the layers of the stack and said germanium layer needs to be protected to avoid lateral attack during patterning of a layer situated under said germanium layer, the ratio of the boron-halogen compound to nitrogen is higher than 19:1. More preferred said ratio of the boron-halogen compound to nitrogen is higher than 11:1 and most preferred the ratio of the boron-halogen compound to nitrogen is 9:1.

For the patterning of germanium comprising stacks wherein germanium is at least one of the layers of the stack said germanium layer needs to be protected to avoid lateral attack during patterning of a layer situated under said germanium layer, the ratio of BCl₃ to nitrogen is higher than 19:1. More preferred said ratio of BCl₃ to nitrogen is higher than 11:1 and most preferred the ratio of BCl₃ to nitrogen is 9:1.

In a preferred embodiment of the invention, the plasma composition is preferably a plasma comprising (or consisting of) a Boron-halogen compound and nitrogen, or in other words small additions of nitrogen in a boron-halogen plasma.

Preferably, the plasma comprises (or consists of) a boron-halogen compound and 5% up to 10% nitrogen (of the total plasma composition).

More preferred, the plasma composition comprises (or consists of) a boron-halogen compound and less than 10% nitrogen (of the total plasma composition) and most preferred said boron-halogen is BCl₃.

For the patterning of germanium comprising stacks wherein said germanium layer needs to be protected to avoid lateral attack during patterning of a layer situated under said germanium layer, the amount of N₂ to the total BCl₃/N₂ plasma composition is higher than 5%, more preferred said amount of N₂ is higher than 8% N₂ to the total BCl₃/N₂ plasma composition and most preferred said amount of N₂ is 10% to the total BCl₃/N₂ plasma composition.

For the patterning of metal gates such as TaN and/or combinations of TaN and TiN (TaN/TiN metal gates) the amount of N₂ to the total BCl₃/N₂ plasma composition is lower than 10%, more preferred said amount of N₂ is lower than 8% N₂ to the total BCl₃/N₂ plasma composition and most preferred said amount of N₂ is 5% to the total BCl₃/N₂ plasma composition.

Preferably the plasma of the present invention (during patterning) has a substrate bias which is different from zero.

Preferably the plasma of the present invention (during patterning) has a plasma power is in the range of 100W up to 1200W. More preferred said plasma power is around 450W.
Preferably the plasma of the present invention (during patterning) has a pressure in the plasma chamber of minimum 0.666 Pa (5mT) and maximum 10.665 Pa (80mT). More preferred said pressure is 0.666 Pa (5mT).

Preferably the plasma of the present invention (during patterning) has a temperature below 100°C and most preferred said plasma temperature during dry-etch patterning is around 60°C. A boron-nitrogen (BₓN_{y} or BN) film deposited at higher temperatures is equal to a higher quality film containing less (or no) impurities which is more difficult or even not possible to remove.

It is further an object of the present invention to provide a method for the dry etching of non-Si comprising gate stacks, said non-Si comprising gate stacks are preferably metal gate comprising gate stacks such as TaN comprising gate stacks and preferably metal gate stacks comprising a (pure) germanium layer.

More specifically the dry-etching method of the invention uses a plasma composition wherein at least one layer of said stack is too sensitive to one of the etch compounds.

Said dry etching method is characterized in that the vertical profile of said gate stack is preserved after etching. The method of the invention solves the problem of negatively sloped gate profiles after dry etching by depositing a sacrificial layer during the etching. Said sacrificial layer serves as a passivating layer during dry etching such that the vertical profile or CD of the gate stack is preserved.

The dry-etching method of the invention solves the problem of lateral etch and profile attack during the patterning of advanced gate stacks such as metal gate stacks and germanium comprising stacks by adding small amounts of nitrogen to a boron-halogen plasma such as BCl₃ plasma in order to improve gate profile control. The mixture of BCl₃/N₂ plasma results in a deposition of BxNy-like film that inhibits the lateral etch but does not inhibit vertical etch as the formed BxNy-like film is destroyed by ion bombardment.

Preferably the method of the invention comprises the steps of first applying a dry-etch step using the plasma composition of the invention whereby during the etching a protective and water-soluble film is deposited onto the vertical sidewalls of said structure such that the vertical profile of said structure is preserved and lateral attack is avoided. In a next step said water-soluble film is removed from said structure.

Said water-soluble film is preferably removed using a wet removal process, most preferred said wet removal is using water.

The dry-etching method of the invention uses a Boron-halogen comprising plasma with small additions of nitrogen.

The Boron-halogen compound is preferably BCl₃ and said small additions of nitrogen are such that the ratio of the boron-halogen compound to nitrogen is in the range of 19:1 up to 9:1.

Optionally an inert compound can be added to the plasma comprising boron-halogen and nitrogen. Said inert compound can be e.g. argon or helium (He) and these compounds can be added to the plasma in concentrations up to 50% of the total plasma composition.

In a method of the invention for patterning metal gates such as TaN metal gates and metal gates comprising combinations of TaN and TiN (TaN/TiN metal gates), the ratio of the boron-halogen compound to nitrogen is preferably below 9:1. More preferably, said ratio of the boron-halogen compound to nitrogen is below 11:1 and most preferred said ratio of the boron-halogen compound to nitrogen is 19:1.

In particular, said boron-halogen compound is BCl₃.

In a method of the invention for patterning germanium comprising stacks, wherein said germanium layer is a layer of the stack which needs to be protected to avoid lateral attack during patterning of a layer situated under said germanium layer, the ratio of the boron-halogen compound to nitrogen is preferably higher than 19:1. More preferred said ratio of the boron-halogen compound to nitrogen is higher than 11:1 and most preferred the ratio of the boron-halogen compound to nitrogen is 9:1.

In particular, said boron-halogen compound is BCl₃.

In a preferred embodiment of the invention, the plasma composition used in a method of the invention is a plasma comprising (or consisting of) a Boron-halogen compound and nitrogen, or in other words small additions of nitrogen in a boron-halogen plasma.

Preferably, the plasma comprises (or consists of) a boron-halogen compound and 5% up to 10% nitrogen (of the total plasma composition).

More preferred, the plasma composition comprises (or consists of) a boron-halogen compound and less than 10% nitrogen (of the total plasma composition) and most preferred said boron-halogen is BCl₃.

In a method of the invention for patterning germanium comprising stacks wherein said germanium layer needs to be protected to avoid lateral attack during patterning of a layer situated under said germanium layer, the amount of N₂ to the total BCl₃/N₂ plasma composition is higher than 5%, more preferred said amount of N₂ is higher than 8% N₂ to the total BCl₃/N₂ plasma composition and most preferred said amount of N₂ is 10% to the total BCl₃/N₂ plasma composition.

In a method of the invention for patterning metal gates such as TaN and/or combinations of TaN and TiN (TaN/TiN metal gates), the amount of N₂ to the total BCl₃/N₂ plasma composition is lower than 10%, more preferred said amount of N₂ is lower than 8% N₂ to the total BCl₃/N₂ plasma composition and most preferred said amount of N₂ is 5% to the total BCl₃/N₂ plasma composition.

Preferably the plasma used in a method of the invention (during patterning) has a substrate bias which is different from zero.

Preferably, said plasma has a plasma power in the range of 100W up to 1200W. More preferred said plasma power is around 450W.
Preferably, said plasma has a pressure in the plasma chamber of minimum 0.666 Pa (5mT) and maximum 10.665 Pa (80mT). More preferred said pressure is 0.666 Pa (5mT).

Preferably, said plasma has a temperature below 100°C and more preferred said plasma temperature during dry-etch patterning is around 60°C.

Indeed, a boron-nitrogen (BₓN_{y} or BN) film deposited at higher temperatures is equal to a higher quality film containing less (or no) impurities, which is more difficult or even not possible to remove.

In relation to the drawings the present invention can also be described as follows in the text below.

It is an object of the present invention to provide a method for the dry etching of non-Si comprising gate stacks, said non-Si comprising gate stacks are preferably metal gate comprising gate stacks such as TaN comprising gate stacks and preferably pure germanium comprising metal stacks. Said dry etching method is characterized in that the vertical profile of said gate stack is preserved after etching. The method of the invention solves the problem of negatively sloped gate profiles after dry etching by depositing a sacrificial layer during the etching. Said sacrificial layer serves as a passivating layer during dry etching such that the vertical profile or CD of the gate stack is preserved.

The present invention discloses a composition of a plasma used to etch materials that are too sensitive to Cl-based plasmas. If those materials are etched with pure Cl-based plasmas such as BCl₃ plasmas, the etch profiles are distorted because these materials are etched in the lateral direction as well. Examples of said materials are metal gate comprising gate stacks such as TaN comprising gate stacks and pure germanium comprising metal stacks. The plasma of the invention solves the problem of damage caused by Cl-based plasmas, more specifically this is achieved by adding small amounts of nitrogen to the Cl-based plasma. For the patterning of metal gate comprising gate stacks such as TaN comprising gate stacks and pure germanium comprising metal stacks said Cl compound is preferably BCl₃. The amount of nitrogen added to the plasma is preferably between 5% up to 10%. The addition of nitrogen to a Cl-based plasma such as BCl₃ preserves the vertical profile through the formation of a passivating BₓN_{y}-like layer on the vertical surfaces.

It is further an aim of the invention to disclose the use of a Cl-based plasma with small additions of nitrogen for the patterning of non-Si based stacks. Said patterning is further characterized as a patterning which avoids lateral etching and preserves the vertical profile. Said stacks are preferably metal gate comprising gate stacks such as TaN comprising gate stacks and preferably pure germanium comprising metal stacks. For patterning TaN comprising gate stacks and pure Germanium comprising gate stacks, said Cl compound is BCl₃.

### EXAMPLES

The method of the current invention as well as the plasma and its use can be applied to any material that can be etched by Cl-based plasma but is too chemically reactive and has significant lateral etch component. Said lateral etch can be blocked by a BxNy-like passivation film deposited onto the vertical sidewalls while at the meanwhile the vertical etch is not significantly affected.

The BCl₃/N₂ plasma was applied for patterning of two different stacks as described in example 1 and 2: pure Ge gates and TaN metal gates in the TiN/TaN gate stack. In both cases, the lateral attack of the gate material was prevented by addition of small amount of N₂ (5%-10%) to the BCl₃ plasma. Furthermore the plasma settings were optimized and illustrated in example 3. The deposited (passivation) BxNy-like layer of the present invention is characterized by FTIR and illustrated in example 4.

### Example 1: Application of BCl₃/N₂ plasma for TaN gate profile control.

The BCl₃/N₂ plasma was used to etch TaN metal gates, in the example presented here said TaN metal gate is present in a TiN/TaN gate stack where 15 nm TaN is in the contact with the gate dielectric and 70 nm TiN covers the TaN or in other words 70nm TiN is situated on top of said 15 nm TaN.

The most critical step is TaN etching after TiN patterning. BCl₃ plasma is used here for the TaN patterning as it is selective to the Si substrate and can be used as high-k removal as well.

If TaN is etched with pure BCl₃ plasma, then a notch (lateral attack) is observed in the TaN layer.

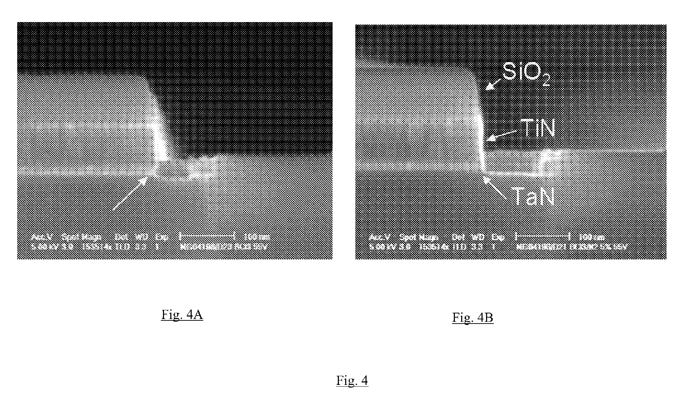

Figure 4A shows the gate profile after etching in pure BCl₃, an arrow indicates the lateral attack of TaN.

The addition of 5% of N₂ to the BCl₃ plasma resulted in a straight TaN profile without the lateral attack of the TaN layer.

The effect of N₂ addition is illustrated in Figure 4B. A BₓN_{y} comprising passivation layer will be deposited onto the vertical sidewalls of the stack during patterning, said BₓN_{y} comprising passivation layer will protect the TaN during patterning and avoid lateral attack.

The deposition of a BₓN_{y} comprising layer onto the horizontal surfaces will be negligible due to a continuous ion bombardment in the vertical direction (in other words the BₓN_{y} comprising layer will be removed immediately after deposition onto horizontal surfaces).

This means that the deposition of the BxNy like film inhibits the lateral etch but does not inhibit vertical etch as the formed BxNy-like film is destroyed by ion bombardment.

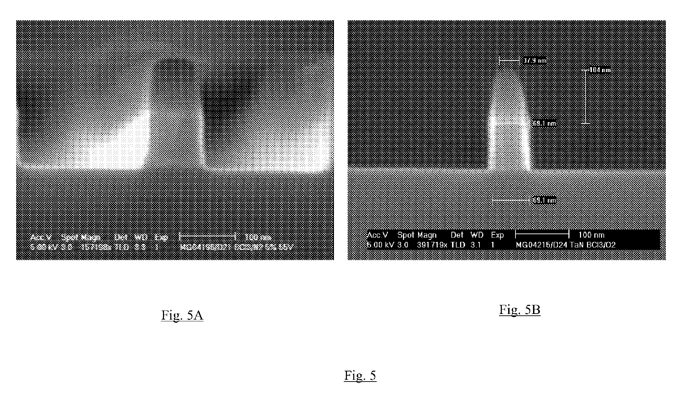

It should be noted that a straight TaN profile could also be obtained by using a BCl₃/O₂ plasma mixture, as shown in Figure 5B. However, the presence of O₂ in the etching plasma will have a detrimental effect on the high-k dielectric and, therefore, should be avoided.

After patterning of the TaN comprising gate stack, the BₓN_{y} comprising passivation layer could be removed by a wet treatment e.g. a removal in water.

### Example 2: Application of BCl₃/N₂ plasma for pure Ge gate profile control.

The BCl₃/N₂ plasma was used to pattern pure Ge gates having a high-k dielectric underneath (in the presented case the high-k dielectric is HfO₂). The high-k dielectric must be removed selectively to the underlying Si substrate.

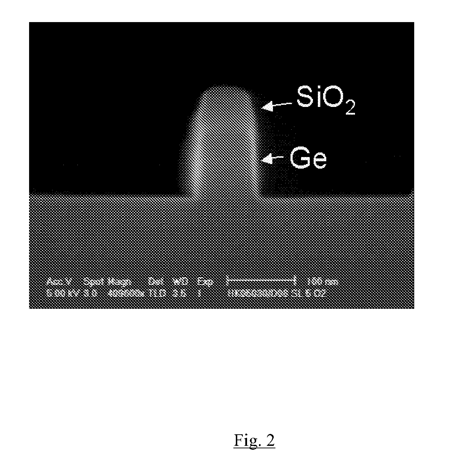

The Ge gate profile just after patterning and before high-k removal as shown in Figure 2 is straight.

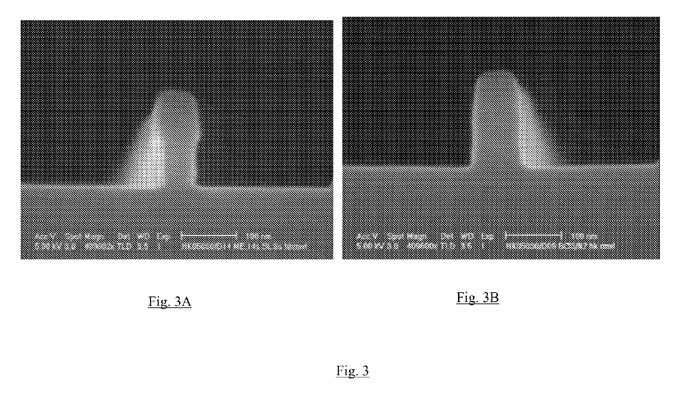

The conventional way of HfO₂ removal is etching in BCl₃ plasma. If high-k is removed by such plasma, the Ge gate suffers from profile distortion while addition of 10% N₂ to the BCl₃ plasma preserves the profile even if the removal time is doubled as shown in Figure 3.

Figure 3A shows the Ge gate profile after high-k removal by a pure BCl₃ plasma for 10 seconds and Figure 3B shows the Ge gate profile after high-k removal by a BCl₃/N₂ (10% N₂) plasma for 20 seconds. No lateral attack of the Ge profile is seen in Figure 3B.

It can be concluded that addition of small amounts of N₂ (in the presented case 10% N₂ was added) to the BCl₃ plasma during high-k removal preserves the shape of the Ge gate. This is due to the deposition of a BxNy-like passivation film on the gate (vertical) sidewalls. Said BxNy-like passivation film is a sacrificial layer which can be removed afterwards by wet treatment.

### Example 3: Plasma parameters used to deposit a BxNy passivation film.

The plasma parameters used for the deposition of a BxNy passivation film during TaN metal gate patterning as presented in example 1 using the plasma of the current invention can be as follows:
Pressure 0.666 Pa (5 mT),
plasma power 450W,
flow BCl₃ 95sccm (standard centimeter cube per minute),
flow N₂ 5 sccm,
substrate bias: 55V.

The plasma parameters used for the deposition of a BxNy passivation film during high-k removal in a Ge gate stacks as presented in example 2 can be as follows:
Pressure 0.666 Pa (5 mT),
plasma power 450W,
substrate bias 30V,
BCl₃ 90 sccm,
N₂ 10 sccm.

### Example 4: Characterization of the deposited BxNy layer

Using the plasma composition (BCl₃/N₂) and method of the present invention resulted in the deposition of a BxNy layer. Said BxNy film was characterized by Fourier Transmission Infra-Red spectrometry (FTIR) and X-ray Photoelectron Spectroscopy (XPS). It was found that a plasma mixture of BCl₃ and N₂ resulted in the deposition of a BxNy film onto a (flat) wafer surface if no bias was applied to the substrate (to avoid ion bombardment). Said BxNy film was deposited in an etch chamber (LAM Versys 2300) at 60°C and 275°C at a rate as high as 300 nm/min depending on the pressure, plasma power, gas flows and BCl₃ to N₂ ratio.

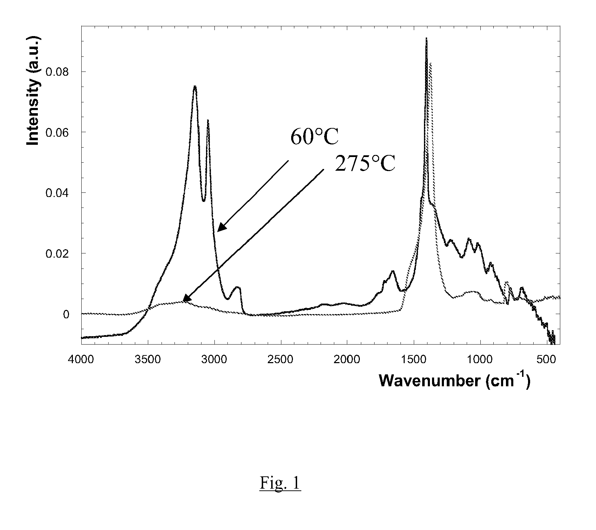

The FTIR spectra of the BxNy films deposited at 60°C and 275°C (for comparison) are shown in Figure 1. A strong peak at about 1400 cm⁻¹ is attributed to a hexagonal boron nitride (h-BN). This peak dominate the spectrum of the film deposited at 275°C but the spectrum of the film deposited at 60°C contains number of other peaks and, therefore, that film is not pure BN.

The XPS analysis of the surface of the film deposited at 60°C showed primarily boron (about 36%), nitrogen (about 20%) and oxygen (about 36%). Some carbon (about 7%) is attributed to the contamination from the atmosphere. The amount of chlorine did not exceed 1%. As the deposition plasma contains no O₂, the significant amount of oxygen in the film is a sign of the film oxidation during the atmosphere exposure.

The deposited BxNy-like film was found to be easily decomposing by temperature (the film thickness decreases at temperatures above 100°C) and soluble in water at room temperatures. These properties make cleaning of any deposited inhibitor layer easy: the water rinse is enough to clean any BxNy-like film that is left after the gate patterning.

It can be concluded that by mixing BCl₃ and N₂ in a plasma etch chamber it is possible to deposit a BxNy-like film that contains almost no Cl₂. The film is relatively unstable and can be easily removed by a water rinse, as it is soluble in water.

## Claims

1. A dry-etch plasma composition for preserving the vertical profile of a structure comprising a stack of layers, said plasma composition **characterized** such that during the dry-etch patterning of said stack a water-soluble film which is removable against the structure, is deposited onto the sidewalls of said stack such that lateral attack of said patterned stack is avoided.

2. The plasma composition of claim 1, said plasma comprising a boron-halogen compound and nitrogen.

3. The plasma composition of claim 1 further comprising an inert compound.

4. The plasma composition of claim 1 or 2, wherein the ratio of the boron-halogen compound to nitrogen is from 19:1 up to 9:1.

5. The plasma composition of any of claims 1 to 4, wherein said boron-halogen compound is BCl₃.

6. The plasma composition of any of the foregoing claims, wherein said stack of layers is a metal gate comprising stack.

7. The plasma composition of claim 6, wherein said metal gate comprising stack comprises TaN or combinations of TaN and TiN (TaN/TiN metal gates).

8. The plasma composition of any of claims 1 to 5, wherein at least one layer of said stack of layers is a germanium comprising layer.

9. The plasma composition of claim 8, wherein said germanium layer is situated upon a layer to be patterned by said plasma composition.

10. The plasma composition of any of claims 1 to 9, wherein the substrate bias is different from zero.

11. The plasma composition of any of claims 1 to 10, wherein the plasma power is in the range of 100W up to 1200W.

12. The plasma composition of claim 11, wherein the plasma power is around 450W.

13. The plasma composition of any of claims 1 to 12, wherein the pressure in the plasma chamber is minimum 0.666 Pa (5mT) and maximum 10.665 Pa (80mT).

14. The plasma composition of any of claims 1 to 13, wherein the pressure in the plasma chamber is 0.666 Pa (5mT).

15. The plasma composition of any of claims 1 to 14, wherein the temperature of the plasma during patterning is below 100°C.

16. The plasma composition of any of claims 1 to 15, wherein the temperature of the plasma during patterning is around 60°C.

17. The plasma composition of any of the foregoing claims, said plasma consisting of a boron-halogen compound and 5% up to 10% nitrogen (of the total plasma composition).

18. The plasma composition of claim 17, said plasma consisting of a boron-halogen compound and less than 10% nitrogen (of the total plasma composition).

19. The plasma composition of claim 17 or 18, said plasma consisting of a boron-halogen compound and less than 8% nitrogen (of the total plasma composition).

20. The plasma composition of any of the foregoing claims, wherein said plasma is a BCl₃ plasma with 5% nitrogen (of the total plasma composition).

21. An anisotropical dry etching method using a plasma composition comprising a boron halogen compound and nitrogen for patterning a stack of layers to create a vertical structure wherein lateral attack during patterning of said stack is avoided, said method comprising the steps of:
- applying a dry-etch step using said plasma wherein during the etching a protective and water-soluble film is deposited onto the vertical sidewalls of said structure such that the vertical profile of said structure is preserved and lateral attack is avoided,
- removing said water-soluble film from said structure.

22. The method of claim 21 wherein said water-soluble film is removed using a wet removal process using water.

23. The method of claim 21 to 22, wherein the ratio of boron-halogen compound to nitrogen is from 19:1 up to 9:1.

24. The method of any of claims 21 to 23, wherein said boron-halogen compound is BCl₃.

25. The method of any of claims 21 to 24, wherein said plasma further comprises an inert compound.

26. The method of any of claims 21 to 25, wherein said stack of layers is a metal gate comprising stack.

27. The method of any of claims 21 to 26, wherein said metal gate comprising stack comprises a TaN layer or combinations of a TaN layer and a TiN (TaN/TiN metal gates).

28. The method of any of claims 21 to 27, wherein at least one layer of said stack of layers is a germanium layer, or a germanium comprising layer.

29. The method of claim 28 wherein said germanium (comprising) layer is situated upon a layer to be patterned by said plasma composition.

30. The method of any of claims 21 to 29, wherein the substrate bias during patterning is different from zero.

31. The method of any of claims 21 to 30, wherein the plasma power during patterning is in the range of 100W up to 1200W.

32. The method of any of claims 21 to 31, wherein the plasma power during patterning is around 450W.

33. The method of any of claims 21 to 32, wherein the pressure in the plasma chamber during patterning is minimum 0.666 Pa (5mT) and maximum 10,665 Pa (80mT).

34. The method of any of claims 21 to 33, wherein the pressure in the plasma chamber during patterning is 0.666 Pa (5mT).

35. The method of any of claims 21 to 34, wherein the temperature of the plasma during patterning is below 100°C.

36. The method of any of claims 21 to 35, wherein the temperature of the plasma during patterning is around 60°C.

37. The method of any of claims 21 to 36, wherein said plasma consists of a boron-halogen compound and 5% up to 10% nitrogen (of the total plasma composition).

38. The method of any of claims 21 to 37, wherein said plasma consists of a boron-halogen compound and less than 10% nitrogen (of the total plasma composition).

39. The method of any of claims 21 to 38, wherein said plasma consists of a boron-halogen compound and less than 8% nitrogen (of the total plasma composition).

40. The method of any of claims 21 to 39, wherein said plasma is a BCl₃ plasma with 5% nitrogen (of the total plasma composition).
